(19) Europäisches Patentamt
European Patent Office
Office européen des brevets

(11) Publication number: **0 422 667 A1**

# (12) EUROPEAN PATENT APPLICATION

(21) Application number: **90119599.0**

(22) Date of filing: **12.10.90**

(51) Int. Cl.5: **G03F 7/004**, G03F 7/022

(30) Priority: **13.10.89 JP 266993/89**

(43) Date of publication of application:
**17.04.91 Bulletin 91/16**

(84) Designated Contracting States:
**BE DE FR GB IT NL**

(71) Applicant: **SUMITOMO CHEMICAL COMPANY, LIMITED**
**Kitahama 4-chome 5-33**
**Chuo-ku Osaka 541(JP)**

(72) Inventor: **Takahashi, Kenji**
**2-14-7, Mefu**
**Takarazuka-shi, Hyogo-ken(JP)**
Inventor: **Hanamoto, Yukio**
**2-10-3-317, Sonehigashi-machi**
**Toyonaka-shi, Osaka-fu(JP)**
Inventor: **Osaki, Haruyoshi**
**2-10-3-311, Sonehigashi-machi**
**Toyonaka-shi, Osaka-fu(JP)**

(74) Representative: **Vossius & Partner**
**Siebertstrasse 4 P.O. Box 86 07 67**
**W-8000 München 86(DE)**

## (54) Radiation-sensitive positive resist composition.

(57) A positive resist composition comprising an alkali-soluble resin, a quinonediazide compound and a solvent comprising 3-methoxybutyl acetate, which forms a resist film having a smaller striation.

EP 0 422 667 A1

Xerox Copy Centre

# RADIATION-SENSITIVE POSITIVE RESIST COMPOSITION

The present invention relates to a novel radiation-sensitive positive resist composition.

In comparison with negative resists, positive resists are preferably used for miniaturization of electronic elements, in particular integrated circuits because the positive resist compositions have more excellent resolution.

The positive resist comprises a sensitizer, a film-forming material and a solvent in which the sensitizer and the film-forming material are dissolved. With a positive resist, fine patterns are formed by coating the resist composition on a substrate by a spin-coating method and the like, removing the solvent by baking, exposing the coated substrate to active light through a mask pattern, dipping the exposed substrate in a developer comprising a 1-3 % aqueous alkaline solution and selectively removing regions which are exposed through utilization of solubility difference between the exposed regions and unexposed regions.

In general, a solvent contained in the commercially available positive resist compositions is ethylcellosolve acetate. With ethylcellosolve acetate, an aromatic hydrocarbon such as toluene or xylene or an ester such as ethyl acetate or butyl acetate may be used together.

Since the miniaturization of patterns in the integrated circuits proceeds more and more as the degree of integration increases year by year and further the diameter of a silicon wafer is increased, formation of a uniform coating film is strictly required.

However, the positive resist composition comprising the conventional solvent cannot be uniformly coated on the substrate with a spinner, because, on the surface of a coated film, radially extending stripes are formed, that is, the degree of so-called striation is larger. As the result, uniformity of the film thickness is lost due to an irregular surface, and hence the pattern size is inevitably changed by a standing wave effect and a bulk effect. The standing wave effect is generated by multiple reflection of the irradiated light in the coated film of the resist, and the bulk effect is generated by light absorption in the resist film. Accordingly, the change of film thickness greatly influences the dimension of resist patterns. The change of resist pattern dimension with the change of film thickness influences performance of LSI and results in decrease of a yield.

An object of the present invention is to provide a positive resist composition which has small striation.

Accordingly, the present invention provides a positive resist composition comprising an alkali-soluble resin, a quinonediazide compound and a solvent which comprises 3-methoxybutyl acetate.

The quinonediazide compound to be used as a sensitizer in the positive resist composition of the present invention is not limited. Specific examples of the quinonediazide compound are 1,2-benzoquinone diazide-4-sulfonic acid ester, 1,2-naphthoquinone diazide-4-sulfonic acid ester and 1,2-naphthoquinone diazide-5-sulfonic acid ester.

Above esters may be prepared by per se conventional methods. For example, the ester is prepared by a condensation reaction of a compound having hydroxyl groups with 1,2-naphtoquinone diazide sulfonyl chloride or benzoquinone diazide sulfonyl chloride in the presence of a weak alkali.

Examples of the compound having a hydroxyl group are hydroquinone, resorcinol, phloroglucin, 2,4-dihydroxybenzophenone, 2,3,4-trihydroxybenzophenone, 2,3,4,4′-tetrahydroxybenzophenone, 2,2′,4,4′-tetrahydroxybenzophenone, bis(p-hydroxyphenyl)methane, bis(2,4-dihydroxyphenyl)methane, bis(2,3,4-trihydroxyphenyl)methane, 2,2-bis(p-hydroxyphenyl)propane, 2,2-bis(2,4-dihydroxyphenyl)propane, 2,2-bis(2,3,4-trihydroxyphenyl)propane, hydroxyflavan and compounds of the formula:

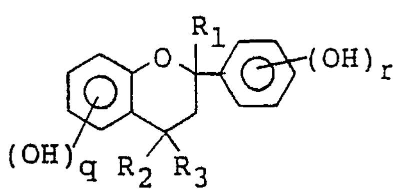

wherein q is a number of 0 to 4, r is a number of 1 to 5, $R_1$, $R_2$ and $R_3$ are independently a hydrogen atom, an alkyl group, an alkenyl group, a cyclohexyl group or an aryl group.

The positive resist composition of the present invention may contain two or more quinonediazide compounds in combination.

The alkali-soluble resin to be used is not limited. Preferred examples of the alkali-soluble resin are polyvinylphenol and a novolak resin. The novolak resin is prepared by an addition condensation reaction of a phenol compound with formaldehyde. Specific examples of the phenol compound used as one of the raw materials for the synthesis of the novolak resin include phenol, o-cresol, m-cresol, p-cresol, 2,5-xylenol, 3,5-xylenol, 3,4-xylenol, 2,3,5-trimethylphenol, 4-tert.-butylphenol, 2,-tert.-butylphenol, 3-tert.-butylphenol, 3-ethylphenol, 2-ethylphenol, 4-ethylphenol, 3-methyl-6-tert.-butylphenol, 4-methyl-2-tert.-butylphenol, 2-naphtol, 1,3-dihydroxynaphthalene, 1,7-dihydroxynaphthalene and 1,5-dihydroxynaphthalene. These phenols may be used alone or in combination.

A preferable weight ratio of the sensitizer to the alkali-soluble resin is from 1:1 to 1:7.

3-Methoxybutyl acetate which is used as the main component of a solvent in the positive resist composition is represented by the formula:

$$\begin{array}{l}\quad OCH_3 \\ \quad | \\ CH_3CHCH_2CH_2OCOCH_3\end{array}$$

The degree of striation greatly depends on properties of the solvent. Although factors which influence striation have not been clarified completely, it has been found that a vapor pressure of the solvent, interaction between the solvent and the resin as well as conditions and atmosphere for spinning a wafer during coating the resist composition have influences on striation. 3-Methoxybutyl acetate is suitable as a solvent in the resist composition since it has a proper vapor pressure and good interaction with the alkali-soluble resin, in particular the novolak resin and achieves very small striation by itself.

3-Methoxybutyl acetate can be used in combination with an aromatic hydrocarbon (e.g. toluene and xylene) or an ester (e.g. ethyl acetate and butyl acetate). An amount of 3-methoxybutyl acetate is preferably from 30 to 100 % by weight, more preferably from 60 to 100 % by weight based on the whole weight of the solvent.

The use of xylene in the solvent of the resist composition decreases striation. However, since solubility of a sensitizer in xylene is low, the use of xylene in a large amount results in recrystallization of the sensitizer, which leads to bad storage stability.

When butyl acetate is contained in the resist composition, wettability of the wafer surface is improved while the wafer surface treated with vapor of hexamethyldisilazane has deteriorated wettability. However, a too large amount of butyl acetate tends to increase the degree of striation and recrystallization of a sensitizer.

An amount of the solvent to be used in the present invention is not limited insofar as the resist composition can be coated to form a uniform film without pin holes and coating irregularity. Generally, the resist composition is adjusted to contain 3 to 50 % by weight of the solid components, namely the sensitizer and the resin.

The positive resist composition of the present invention may further contain another sensitizer, another resin, a surfactant, a stabilizer, a dye which improves visibility of the formed image, or other additives which are usually used in this technical field.

A preferred example for using the positive resist composition of the present invention is explained now.

On a silicon wafer, the positive resist composition is coated by a conventional method such as spin coating, and the coated silicon wafer is prebaked on a direct contact hot plate to form a solvent-free coating film. Then, the silicon wafer is exposed to light by means of a reduction projection exposure apparatus through a reticle on which desired mask patterns are drawn. Thereafter, the silicon wafer is developed in a developer such as a 1 to 3 % aqueous solution of tetramethylammonium hydroxide with an automatic developing machine. Solubilized parts are selectively removed to leave a positive image which is an exactly reduced image of the mask pattern.

The positive resist composition of the present invention can provide a uniform coating film with small striation stably for a long time.

The present invention will be illustrated in more detail with the following Example, but it is not limited to this Example.

## Example

Alkali-soluble cresol-formaldehyde novolak resin (14.5 g) and a sensitizer (a condensation product of naphthoquinone-(1,2)-diazide-(2)-5-sulfonic acid chloride with 2,3,4,4′-tetrahydroxybenzophenone) (4.8 g) were dissolved in 3-methoxybutyl acetate (48 g) and the resulting solution was filtered through a filter of 0.2 µm in pore size to prepare a resist solution. The resist solution was then coated on a silicon wafer by means of a spinner at 4000 rpm in a usual manner. The coated silicon wafer was baked for one minute on a direct hot plate kept at 100 °C. The formed film had a thickness of 1.19 µm, which was measured with Lambda A (trade name) manufactured ty Dainippon Screen Manufacturing Co., Ltd.. The striation of the coated film was not more than 50 Å when measured with Talistep (trade name) manufactured by Rank Taylor Hobson Limited.

## Comparative Example

In the same manner as in Example 1 but using ethylcellosolve acetate in place of 3-methoxybutyl acetate, a coated film was formed. The coated film had a thickness of 1.25 µm and striation of 150 to 200 Å.

**Claims**

1. A positive resist composition comprising an alkali-soluble resin, a quinonediazide compound and a solvent which comprises 3-methoxybutyl acetate.
2. The positive resist composition according to claim 1, wherein said quinonediazide compound is at least one selected from the group consisting of 1,2-benzoquinone diazide-4-sulfonic acid ester, 1,2-naphthoquinone diazide-4-sulfonic acid ester and 1,2-naphthoquinone diazide-5-sulfonic acid ester.
3. The positive resist composition according to claim 1, wherein the weight ratio of said sensitizer to said alkali-soluble resin is from 1:1 to 1:7.
4. The positive resist composition according to claim 1, wherein said solvent comprises 3-methoxybutyl acetate and at least one other solvent selected from the group consisting of toluene, xylene, ethyl acetate and butyl acetate.
5. The positive resist composition according to claim 1, wherein the amount of 3-methoxybutyl acetate in said solvent is from 30 to 100 % by weight based on the whole weight of the solvent.
6. The positive resist composition according to claim 1, wherein the solid content is from 3 to 50 % by weight.

European Patent Office

# EUROPEAN SEARCH REPORT

Application Number

**EP 90 11 9599**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 206 261 (HOECHST AG)<br>* column 3, line 52 - column 4, line 17 * * Beispiele *<br>– – – | 1-6 | G 03 F 7/004<br>G 03 F 7/022 |
| A | EP-A-0 211 667 (JAPAN SYNTHETIC RUBBER CO., LTD.)<br>* the whole document *<br>– – – – – | 1-7 | |

| TECHNICAL FIELDS SEARCHED (Int. Cl.5) |
|---|
| G 03 F |

The present search report has been drawn up for all claims

| Place of search | Date of completion of search | Examiner |
|---|---|---|
| The Hague | 31 January 91 | LUDI M.M.B. |

CATEGORY OF CITED DOCUMENTS

X: particularly relevant if taken alone
Y: particularly relevant if combined with another document of the same catagory
A: technological background
O: non-written disclosure
P: intermediate document
T: theory or principle underlying the invention

E: earlier patent document, but published on, or after the filing date
D: document cited in the application
L: document cited for other reasons

&: member of the same patent family, corresponding document